# EUROPEAN PATENT APPLICATION

(11) **EP 4 683 445 A1**
(43) Date of publication of application: **21.01.2026**
(21) Application number: 25153359.2
(22) Date of filing: 22.01.2025
(51) Int. Cl.: H05K 7/20

(54) **POWER CONVERSION MODULE AND UNINTERRUPTIBLE POWER SUPPLY**

(30) Priority: 16.07.2024 CN 202421683537 U
(71) Applicant: Vertiv Corporation, Westerville, OH 43082 (US)
(72) Inventor: BAI, Chengkun, Shaanxi, 710005 (CN); YAO, Zhihong, Shaanxi, 710005 (CN); HU, Dawei, Shaanxi, 710005 (CN); XU, Mao, Shaanxi, 710005 (CN)
(74) Representative: Harden, Henry Simon

(57) **Abstract**

Provided in the present disclosure are a power conversion module and an uninterruptible power supply, which relates to the technical field of uninterruptible power supplies. The power conversion module includes a first power conversion board, a second power conversion board and a liquid cooling board. The first power conversion board, the liquid cooling board and the second power conversion board are stacked along a thickness direction of the liquid cooling board, the liquid cooling board is located between the first power conversion board and the second power conversion board, and two side surfaces of the liquid cooling board in the thickness direction are respectively connected to the first power conversion board and the second power conversion board. In this way, a heat dissipation efficiency of the power conversion module is improved.

## Description

The present application claims priority to Chinese Patent Application No. 202421683537.8, titled "Power conversion module and uninterruptible power supply", filed on July 16, 2024 with the China National Intellectual Property Administration, which is incorporated herein by reference in its entirety.

### FIELD

The present disclosure relates to the technical field of uninterruptible power supplies, and in particular to a power conversion module and an uninterruptible power supply.

### BACKGROUND

A data center may be applied to transmit, accelerate, display, calculate, and store data information on network infrastructure. The data center may include an uninterruptible power supply (UPS). The UPS may be utilized to provide uninterrupted power supply to load equipment such as servers and computers.

In order to increase the power of the uninterruptible power supply, the uninterruptible power supply may include a cabinet and a plurality of power conversion modules installed in the cabinet. The power conversion modules produce significant heat during operation.

In related technologies, heat dissipation for the power conversion module is usually realized through air cooling. However, in a case where devices are arranged in the cabinet with a high density, a heat flow density in the cabinet is large, and a heat dissipation efficiency by air cooling is low for the power conversion module.

Therefore, how to improve the heat dissipation efficiency of the power conversion module in the uninterruptible power supply becomes an urgent problem to be solved in the technical field of uninterruptible power supplies.

### SUMMARY

The present disclosure is intended to provide a power conversion module and an uninterruptible power supply, in order to solve the problem of low heat dissipation efficiency of the power conversion module in the uninterruptible power supply in the conventional technology.

In an aspect of the present disclosure, a power conversion module is provided. The power conversion module includes a first power conversion board, a second power conversion board and a liquid cooling board. The first power conversion board, the liquid cooling board and the second power conversion board are stacked along a thickness direction of the liquid cooling board, the liquid cooling board is located between the first power conversion board and the second power conversion board, and two side surfaces of the liquid cooling board in the thickness direction are respectively connected to the first power conversion board and the second power conversion board.

In the power conversion module provided in the present disclosure, heat dissipation for the first power conversion board and the second power conversion board are both realized through liquid cooling by the liquid cooling board. An improved heat dissipation efficiency for the first power conversion board and the second power conversion board is realized, and a heat dissipation requirement of the power conversion module can be satisfied when a device density in the cabinet is high.

In addition, as the liquid cooling board is utilized for dissipating heat from the first power conversion board and the second power conversion board, less noise is generated, so that the uninterruptible power supply is less noisy during operation.

In addition, no ventilation structure is required on the casing, which contributes to improve a dustproof and waterproof level of the uninterruptible power supply.

Furthermore, since the first power conversion board, the liquid cooling board and the second power conversion board are stacked along the thickness direction of the liquid cooling board, the first power conversion board, the liquid cooling board and the second power conversion board are integrated at a high level, which contributes to reduce sizes of the liquid cooling board and the uninterruptible power supply. The liquid cooling board is located between the first power conversion board and the second power conversion board, so that thermal conduction paths from the first power conversion board and the second power conversion board to the liquid cooling board are short, and therefore the liquid cooling board implements a good heat dissipation effect for both the first power conversion board and the second power conversion board.

Alternatively, the first power conversion board includes a first substrate and a first power board heater disposed on the first substrate, the liquid cooling board is located on a side of the first power board heater away from the first substrate, and the first power board heater is connected to one side surface of the liquid cooling board in the thickness direction.

In this way, a heat conduction path between the first power board heater and the liquid cooling board is short, and the liquid cooling board implements a high heat dissipation efficiency for the first power board heater.

Alternatively, the second power conversion board includes a second substrate and a second power board heater disposed on the second substrate, the liquid cooling board is located on a side of the second power board heater away from the second substrate, and the second power board heater is connected to another side surface of the liquid cooling board in the thickness direction.

In this way, a heat conduction path between the second power board heater and the liquid cooling board is short, and the liquid cooling board implements a high heat dissipation efficiency for the second power board heater.

Alternatively, the first substrate includes a first region and a second region, and the first power board heater is disposed in the first region. The second substrate includes a third region and a fourth region, and the second power board heater is disposed in the third region. An orthographic projection of the first region on a reference plane at least partially overlaps an orthographic projection of the third region on the reference plane. The orthographic projection of the first region on the reference plane and the orthographic projection of the third region on the reference plane are both located within an orthographic projection of the liquid cooling board on the reference plane. An orthographic projection of the second region on the reference plane and an orthographic projection of the fourth region on the reference plane are both located outside the orthographic projection of the liquid cooling board on the reference plane. The reference plane is perpendicular to the thickness direction of the liquid cooling board.

In this way, the first power board heater is concentrated in the first region, and the second power board heater is concentrated in the third region. The first power board heater and the second power board heater are arranged in a relatively centralized manner, which is conducive to reducing a size of the liquid cooling board.

Alternatively, the liquid cooling board includes a first surface structure, and the first surface structure is located on a side of the liquid cooling board in the thickness direction. The first surface structure includes a first datum surface, the first power conversion board comprises a plurality of first power board heaters, the plurality of first power board heaters include a first heater and a second heater, a size of the first heater in the thickness direction of the liquid cooling board is greater than a size of the second heater in the thickness direction of the liquid cooling board, the first heater is connected to the first datum surface, a first thermal conductive pad is disposed between the second heater and the first datum surface, and the second heater is connected to the first datum surface via the first thermal conductive pad.

In this way, as the first heater is connected to the first datum surface, the first thermal conductive pad can fill the gap between the second heater and the first datum surface. Hence, the first heater and the second heater, which have a small difference in size in the thickness direction of the liquid cooling board, can both realize heat dissipation through the liquid cooling board.

Alternatively, the liquid cooling board includes a first surface structure, and the first surface structure is located on a side of the liquid cooling board in the thickness direction. The first surface structure includes a first datum surface and a first boss structure protruding from the first datum surface toward the first substrate, the first power conversion board comprises a plurality of first power board heaters, the plurality of first power board heaters include a first heater and a third heater, a size of the first heater in the thickness direction of the liquid cooling board is greater than a size of the third heater in the thickness direction of the liquid cooling board. An orthographic projection of the first heater on a reference plane is located within an orthographic projection of the first datum surface on the reference plane, and the first heater is connected to the first datum surface. At least part of an orthographic projection of the third heater on the reference plane is located within an orthographic projection of an end surface of the first boss structure away from the first datum surface on the reference plane, and the third heater is connected to the end surface of the first boss structure away from the first datum surface.

In this way, as the first heater is connected to the first datum surface, the first boss structure can fill the gap between the third heater and the first datum surface. Hence, the first heater and the third heater, which have a large difference in size in the thickness direction of the liquid cooling board, can both realize heat dissipation through the liquid cooling board.

Alternatively, the third heater includes a first heating element and a first heat dissipation board. The first heating element is disposed on the first substrate, the first heat dissipation board is disposed between the first heating element and the first boss structure, a side of the first heat dissipation board is connected to the first heating element, and another side of the first heat dissipation board is connected to the end surface of the first boss structure away from the first datum surface.

In this way, a heat exchange area between the first heat dissipation board and the liquid cooling board is large, which contributes to improve the heat dissipation effect of the liquid cooling board on the first heating element.

Alternatively, the third heater comprises a plurality of first heating elements, and a side of the first heat dissipation board is connected to the plurality of first heating elements.

In this way, the plurality of first heating elements exchange heat with the liquid cooling board through the first heat dissipation board, realizing a compact structure, and thereby the first heat dissipation board can be arranged easily. In addition, a difficulty of disposing the first boss structure connected to the first heat dissipation board can be reduced.

Alternatively, the first heating element includes a first element body and a first pin, the first element body is disposed on the first substrate via the first pin, a plane where a length direction of the first element body and a width direction of the first element body are located is parallel to the first heat dissipation board, and a side of the first element body away from the first substrate is connected to the first heat dissipation board. A length of the first element body and a width of the first element body are both greater than a thickness of the first element body.

In this way, a heat exchange area between the first element body and the first heat dissipation board is large and the heat exchange efficiency is high, which contributes to improve the heat dissipation efficiency of the liquid cooling board on the first heating element.

Alternatively, the power conversion module further includes a first cover shell and a second cover shell. The first cover shell and the second cover shell are arranged oppositely along the thickness direction of the liquid cooling board, and the first power conversion board, the liquid cooling board and the second power conversion board are located between the first cover shell and the second cover shell. The first power conversion board is located between the second power conversion board and the first cover shell, the first power conversion board is fixedly connected to the first cover shell, the first cover shell is fixedly connected to the liquid cooling board, and the first power conversion board is pressed onto the liquid cooling board by the first cover shell. The second power conversion board is located between the first power conversion board and the second cover shell, the second power conversion board is fixedly connected to the second cover shell, the second cover shell is fixedly connected to the liquid cooling board, and the second power conversion board is pressed onto the liquid cooling board by the second cover shell.

In this way, the liquid cooling board can be closely attached to the first power conversion board and the second power conversion board, so that the liquid cooling board implements a good heat dissipation effect for both the first power conversion board and the second power conversion board.

In another aspect of the present disclosure, an uninterruptible power supply is provided, which includes a cabinet and the power conversion module according to any of the above embodiments. The power conversion module is disposed in the cabinet.

### BRIEF DESCRIPTION OF THE DRAWINGS

For clearer illustration of the technical solutions according to embodiments of the present disclosure or conventional techniques, hereinafter briefly described are the drawings to be used in embodiments of the present disclosure or the conventional techniques. Apparently, the drawings in the following descriptions are some embodiments of the present disclosure, and other drawings can be obtained by those skilled in the art based on the provided drawings without any creative effort.
Figure 1 is a schematic diagram of a power conversion module viewed from a perspective according to an embodiment of the present disclosure;
Figure 2 is a schematic diagram of the power conversion module shown in Figure 1 viewed from another perspective;
Figure 3 is an exploded view of the power conversion module shown in Figure 1;
Figure 4 is a schematic diagram of a power conversion module according to another embodiment of the present disclosure; and
Figure 5 is an exploded view of a first power conversion board of a power conversion module according to an embodiment of the present disclosure.

Reference signs in the drawings are explained and listed below:

| | | | |
|---|---|---|---|
| 100 | First power conversion board; | 110 | First substrate; |
| 111 | First region; | 112 | Second region; |
| 120 | First power board heater; | 120a | First heater; |
| 120b | Second heater; | 120c | Third heater; |
| 121c | First heating element; | | 1211c First element body; |
| 1212c | First pin; | 122c | First heat dissipation board; |
| 200 | Second power conversion board; | 210 | Second substrate; |
| 211 | Third region; | 212 | Fourth region; |
| 220 | Second power board heater; | 220a | Fourth heater; |
| 220b | Fifth heater; | 220c | Sixth heater; |
| 221c | Second heating element; | 2211c | Second element body; |
| 222c | Second heat dissipation board; | | |
| 300 | Liquid cooling board; | 310 | First surface structure; |
| 311 | First datum surface; | 312 | First boss structure; |
| 320 | Second surface structure; | 321 | Second datum surface; |
| 322 | Second boss structure; | | |
| 410 | First thermal conductive pad; | 420 | Second thermal conductive pad; |
| 510 | First thermal interface material; | 520 | Second thermal interface material; |
| 530 | Third thermal interface material; | 540 | Fourth thermal interface material; |
| 550 | Fifth thermal interface material; | 560 | Sixth thermal interface material. |

### DETAILED DESCRIPTION

In order to make the objectives, technical solutions and advantages of the embodiments of the present disclosure clearer, technical solutions of embodiments of the present disclosure are described clearly and completely in conjunction with the drawings of the embodiments of the present disclosure. Apparently, the embodiments described below are some embodiments, rather than all embodiments of the present disclosure. Any other embodiments obtained by those skilled in the art based on the embodiments in the present disclosure without any creative effort shall fall within the protection scope of the present disclosure.

It should be noted that terms "first", "second", and the like, are for descriptive purposes only and cannot be understood as indicating or implying relative importance or implicitly indicating quantities of indicated technical features. Therefore, a feature defined with "first" or "second" may explicitly or implicitly include at least one of the features. In the description of this specification, "plurality" means at least two, such as two or three, unless otherwise expressly and specifically limited.

In the present disclosure, unless otherwise clearly stated and limited, the terms "installation", "connection", "fixing" and other terms should be understood in a broad sense. For example, a connection may be a fixed connection, or a detachable connection, or an integrated connection; a connection may be a direct connection, or an indirect connection through an intermediary, or an internal connection between two elements or an interactive relationship between two elements, unless otherwise clearly limited. For those of ordinary skills in the art, specific meanings of the terms in the present disclosure may be understood on a case-by-case basis.

In the present disclosure, unless otherwise expressly stated and limited, a first feature "on" or "under" a second feature may indicate that the first feature and the second feature are in direct contact, or the first feature and the second feature are in indirect contact through an intermediary. Furthermore, a first feature "above", "over" or "on" a second feature may indicate that the first feature is directly above or diagonally above the second feature, or simply means that the first feature is higher in level than the second feature. A first feature "under", "beneath" or "below" a second feature may indicate that the first feature is directly under or diagonally under the second feature, or simply means that the first feature is lower in level than the second feature.

In the above description, reference terms "an embodiment", "some embodiments", "an example", "specific examples", "some examples", and the like, indicate that specific features, structures, materials, or characteristics described in connection with the embodiment or example are included in at least one embodiment or example of the present disclosure. In this specification, schematic representations of the terms do not necessarily refer to the same embodiment or example. Furthermore, the specific features, structures, materials or characteristics described may be combined in any suitable manner in any one or more embodiments or examples. Furthermore, those skilled in the art may combine and group different embodiments or examples and features of different embodiments or examples described in the specification, unless they are inconsistent with each other.

Provided in embodiments of the present disclosure is a data center. The data center includes an uninterruptible power supply. The uninterruptible power supply is an apparatus for providing uninterrupted power supply to load equipment electrically connected thereto.

For example, the load equipment may include, but is not limited to, a server, a computer, and the like.

For example, the data center may further include a server, and the uninterruptible power supply is electrically connected to the server.

In an embodiment of the present disclosure, the uninterruptible power supply may include a cabinet and a power conversion module disposed in the cabinet. The power conversion module may be configured to convert a type of current into another type of current.

For example, the power conversion module may be configured to convert the mains power into a current for charging a battery; the power conversion module may be configured to convert the mains power into a current required by load equipment; and the power conversion module may be configured to convert a current outputted by a battery into a current required by load equipment.

For example, the uninterruptible power supply may include a plurality of power conversion modules arranged in the cabinet, and the plurality of power conversion modules may be arranged in parallel so that the uninterruptible power supply can have a high power.

In an embodiment of the present disclosure, the power conversion module includes a casing and a power conversion board. The power conversion board is disposed in the casing, and the casing is disposed in the cabinet.

When the uninterruptible power supply is in operation, the power conversion board produces significant heat, and therefore requires highly-effective heat dissipation.

According to a related technology, in order to improve an efficiency of heat dissipation for the power conversion board, a power conversion module may further include a fan disposed in the casing. The fan can perform air cooling for the power conversion board.

However, when the density of devices in the cabinet is high (for example, power conversion modules are disposed in the cabinet at a high density), a heat flow density in the cabinet is usually large, and the heat dissipation efficiency by air cooling for the power conversion board is low. In addition, the heat dissipation by air cooling produces great noise, so that the uninterruptible power supply is noisy when operating. In addition, a ventilation structure is required on the casing for the heat dissipation by air cooling, and therefore the uninterruptible power supply has a low level of dustproof or waterproof.

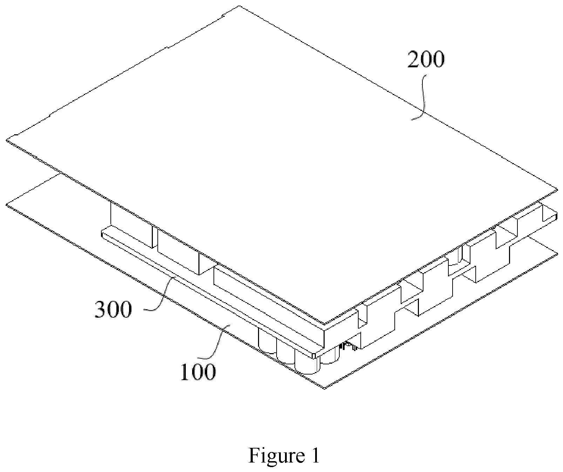

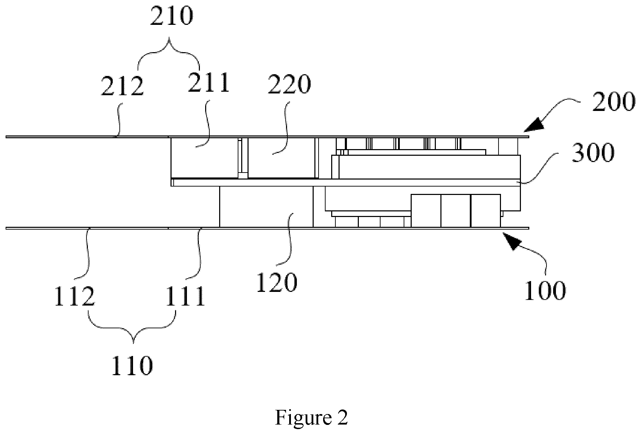

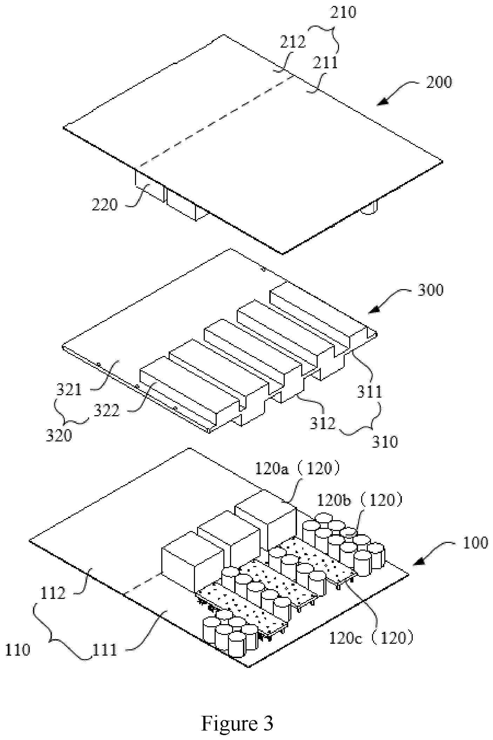

Figure 1 is a schematic diagram of a power conversion module viewed from a perspective according to an embodiment of the present disclosure. Figure 2 is a schematic diagram of the power conversion module shown in Figure 1 viewed from another perspective. Figure 3 is an exploded view of the power conversion module shown in Figure 1.

As shown in Figure 1 to Figure 3, in an embodiment of the present disclosure, the power conversion module includes a casing (not shown), a first power conversion board 100, a second power conversion board 200 and a liquid cooling board 300. The first power conversion board 100, the liquid cooling board 300 and the second power conversion board 200 are all arranged in the casing. The first power conversion board 100, the liquid cooling board 300 and the second power conversion board 200 are stacked along a thickness direction of the liquid cooling board 300, the liquid cooling board 300 is located between the first power conversion board 100 and the second power conversion board 200, and two side surfaces of the liquid cooling board 300 in the thickness direction are respectively connected to the first power conversion board 100 and the second power conversion board 200.

In this way, heat dissipation for the first power conversion board 100 and the second power conversion board 200 are both realized through liquid cooling by the liquid cooling board 300. A high efficiency in heat dissipation for the first power conversion board 100 and the second power conversion board 200 is realized, and a heat dissipation requirement of the power conversion module can be satisfied when a device density in the cabinet is high (for example, the power conversion modules are disposed in the cabinet with a high density). In addition, as the liquid cooling board 300 is utilized for dissipating heat from the first power conversion board 100 and the second power conversion board 200, less noise is generated, so that the uninterruptible power supply is less noisy when operating. In addition, no ventilation structure is required on the casing, which contributes to improve a dustproof and waterproof level of the uninterruptible power supply. Furthermore, since the first power conversion board 100, the liquid cooling board 300 and the second power conversion board 200 are stacked along the thickness direction of the liquid cooling board 300, the first power conversion board 100, the liquid cooling board 300 and the second power conversion board 200 are integrated at a high level, which contributes to reduce sizes of the liquid cooling board 300 and the uninterruptible power supply. The liquid cooling board 300 is located between the first power conversion board 100 and the second power conversion board 200, so that thermal conduction paths from the first power conversion board 100 and the second power conversion board 200 to the liquid cooling board 300 are short, and therefore the liquid cooling board 300 implements a good heat dissipation effect for both the first power conversion board 100 and the second power conversion board 200.

The liquid cooling board 300 includes a first surface structure 310 and a second surface structure 320. The first surface structure 310 and the second surface structure 320 are respectively located of two sides of the thickness direction of the liquid cooling board 300. The first surface structure 310 is connected to the first power conversion board 100, and the second surface structure 320 is connected to the second power conversion board 200.

For example, one of the first power conversion board 100 and the second power conversion board 200 may include a power factor correction (PFC) circuit and a charge-discharge circuit. The other one of the first power conversion board 100 and the second power conversion board 200 may include an inverter circuit. The power factor correction circuit is electrically connected to the charge-discharge circuit and the inverter circuit. The charge-discharge circuit is electrically connected to the inverter circuit. The embodiment of the present disclosure is illustrated by way of an example where the first power conversion board 100 includes the power factor correction circuit and the charge-discharge circuit, and the second power conversion board 200 includes the inverter circuit.

The power factor correction circuit and the inverter circuit cooperate with each other to convert the mains power into a current required by load equipment. The power factor correction circuit and the charge-discharge circuit cooperate with each other to convert the mains power into a current for charging a battery. The charge-discharge circuit and the inverter circuit cooperate with each other to convert a current outputted by a battery into a current required by load equipment.

In a case where the mains power is normal, the mains power may be supplied to the load equipment through the power factor correction circuit and the inverter circuit, and the mains power may be supplied to the battery through the power factor correction circuit and the charge-discharge circuit. In a case where the mains power is abnormal, the battery may supply power to the load equipment through the charge-discharge circuit and the inverter circuit.

For example, the data center further includes a pump, an evaporator, a compressor, a condenser and an expansion valve. The evaporator has a first flow channel and a second flow channel. An end of the liquid cooling board 300 is connected to an end of the first flow channel through the pump. Another end of the liquid cooling board 300 is connected to another end of the first flow channel. The liquid cooling board 300, the pump and the first flow channel form a first circulation flow channel. The first circulation flow channel contains a first refrigerant, and the pump drives the first refrigerant to circulate in the first circulation channel. An output end of the compressor is connected to an end of the condenser, another end of the condenser is connected to an end of the second flow channel through the expansion valve, and another end of the second flow channel is connected to an input end of the compressor. The compressor, the condenser, the expansion valve and the second flow channel form a second circulation flow channel. The second circulation flow channel contains a second refrigerant. The evaporator is configured for heat exchange between the first refrigerant in the first flow channel and the second refrigerant in the second flow channel.

For example, the first refrigerant may include, but is not limited to, cooling water, cooling liquid, and ethylene glycol solution.

For example, the second refrigerant may include, but is not limited to, cooling water, cooling liquid, and ethylene glycol solution.

The first power conversion board 100 includes a first substrate 110 and a first power board heater 120 disposed on the first substrate 110. The first power board heater 120 is a device or component that generates a large amount of heat during operation. For example, the temperature of the first power board heater 120 during operation is higher than a first temperature threshold.

For example, the first substrate 110 is perpendicular to the thickness direction of the liquid cooling board 300.

For example, the first power conversion board 100 may comprise one or more first power board heaters 120.

For example, any of the first power board heaters 120 may include, but is not limited to, an inductor, a capacitor, or a power tube component.

For example, the first substrate 110 may be a circuit board, and the first power board heater 120 may be electrically connected to the first substrate 110.

For example, the first power conversion board 100 may further include a first power board low-temperature component (not shown) disposed on the first substrate 110. The first power board low-temperature component is a device or component that generate less heat during operation. For example, the temperature of the first power board low-temperature component during operation is lower than the first temperature threshold.

In some possible embodiments, the liquid cooling board 300 is located on a side of the first power board heater 120 away from the first substrate 110, and the first power board heater 120 is connected to a surface of a side of the liquid cooling board 300 in the thickness direction, that is, the first power board heater 120 is connected to the first surface structure 310.

In this way, a heat conduction path between the first power board heater 120 and the liquid cooling board 300 is short, and the liquid cooling board 300 implements a high heat dissipation efficiency for the first power board heater 120.

In other examples, the first power board heater 120 is located on a side of the first substrate 110 away from the liquid cooling board 300, and the first substrate 110 is connected to a surface of a side of the liquid cooling board 300 in the thickness direction, that is, the first substrate 110 is connected to the first surface structure 310.

The second power conversion board 200 includes a second substrate 210 and a second power board heater 220 disposed on the second substrate 210. The second power board heater 220 is a device or component that generates a large amount of heat during operation. For example, the temperature of the second power board heater 220 during operation is higher than a second temperature threshold.

For example, the second substrate 210 is perpendicular to the thickness direction of the liquid cooling board 300.

For example, the first temperature threshold may be the same as or different from the second temperature threshold.

For example, the second power conversion board 200 may comprise one or more second power board heaters 220.

For example, any of the second power board heaters 220 may include, but is not limited to, an inductor, a capacitor, or a power tube component.

For example, the second substrate 210 may be a circuit board, and the second power board heater 220 may be electrically connected to the second substrate 210.

For example, the second power conversion board 200 may further include a second power board low-temperature component (not shown) disposed on the second substrate 210. The second power board low-temperature component is a device or component that generate less heat during operation. For example, the temperature of the second power board low-temperature component during operation is lower than the second temperature threshold.

In some possible embodiments, the liquid cooling board 300 is located on a side of the second power board heater 220 away from the second substrate 210, and the second power board heater 220 is connected to a surface of a side of the liquid cooling board 300 in the thickness direction, that is, the second power board heater 220 is connected to the second surface structure 320.

In this way, a heat conduction path between the second power board heater 220 and the liquid cooling board 300 is short, and the liquid cooling board 300 implements a high heat dissipation efficiency for the second power board heater 220.

In other examples, the second power board heater 220 is located on a side of the first substrate 210 away from the liquid cooling board 300, and the second substrate 210 is connected to a surface of a side of the liquid cooling board 300 in the thickness direction, that is, the second substrate 210 is connected to the second surface structure 320.

In some possible embodiments, the first substrate 110 includes a first region 111 and a second region 112, and the first power board heater 120 is disposed in the first region 111. The second substrate 210 includes a third region 211 and a fourth region 212, and the second power board heater 220 is disposed in the third region 211. An orthographic projection of the first region 111 on a reference plane at least partially overlaps an orthographic projection of the third region 211 on the reference plane. The orthographic projection of the first region 111 on the reference plane and the orthographic projection of the third region 211 on the reference plane are both located within an orthographic projection of the liquid cooling board 300 on the reference plane. An orthographic projection of the second region 112 on the reference plane and an orthographic projection of the fourth region 212 on the reference plane are both located outside the orthographic projection of the liquid cooling board 300 on the reference plane. The reference plane is perpendicular to the thickness direction of the liquid cooling board 300.

In this way, the first power board heater 120 is concentrated in the first region 111, and the second power board heater 220 is concentrated in the third region 211. The first power board heater 120 and the second power board heater 220 are arranged in a relatively centralized manner, which is conducive to reducing a size of the liquid cooling board 300.

For example, at least part of the first power board low-temperature component is disposed in the second region 112, and at least part of the second power board low-temperature component is disposed in the fourth region 212.

In some examples, the orthographic projection of the first region 111 on the reference plane is located within the orthographic projection of the third region 211 on the reference plane.

In this way, the first power board heater 120 and the second power board heater 220 are arranged in a relatively centralized manner, which is conducive to reducing a size of the liquid cooling board 300.

In some examples, the orthographic projection of the third region 211 on the reference plane is located within the orthographic projection of the first region 111 on the reference plane.

In this way, the first power board heater 120 and the second power board heater 220 are arranged in a relatively centralized manner, which is conducive to reducing a size of the liquid cooling board 300.

For example, an orthographic projection of the second region 112 on a reference plane at least partially overlaps an orthographic projection of the fourth region 212 on the reference plane.

In this way, the first substrate 110 highly overlaps the second substrate 210, thus a high space utilization rate being achieved, and a size of the uninterruptible power supply being reduced.

In some examples, the orthographic projection of the second region 112 on the reference plane is located within the orthographic projection of the fourth region 212 on the reference plane.

In this way, the first substrate 110 highly overlaps the second substrate 210, thus a high space utilization rate being achieved, and a size of the uninterruptible power supply being reduced.

In some examples, the orthographic projection of the fourth region 212 on the reference plane is located within the orthographic projection of the second region 112 on the reference plane.

In this way, the first substrate 110 highly overlaps the second substrate 210, thus a high space utilization rate being achieved, and a size of the uninterruptible power supply being reduced.

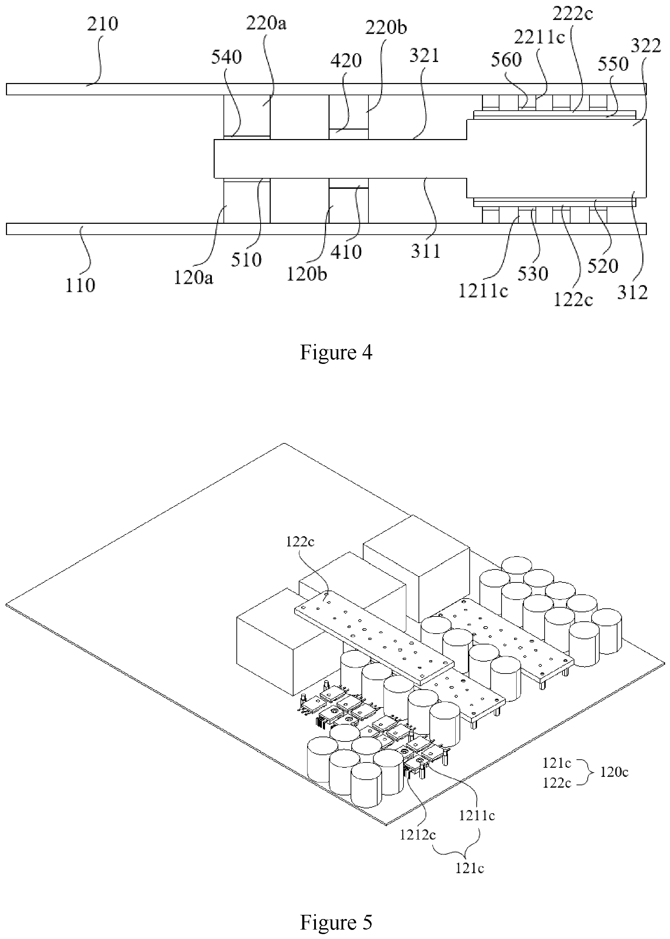

Figure 4 is a schematic diagram of a power conversion module according to another embodiment of the present disclosure.

As shown in Figure 4 and with reference to Figure 3, the first surface structure 310 includes a first datum surface 311.

For example, the first datum surface 311 is perpendicular to the thickness direction of the liquid cooling board 300.

In examples where the first power conversion board 100 includes a plurality of first power board heaters 120 and the first power board heaters 120 are connected to the first surface structure 310, the plurality of first power board heaters 120 include a first heater 120a which is connected to the first datum surface 311.

In this way, a heat conduction path between the first heater 120a and the liquid cooling board 300 is short, and the liquid cooling board 300 implements an improved heat dissipation effect for the first heater 120a.

For example, a first thermal interface material 510 is provided between the first heater 120a and the first datum surface 311, and the first heater 120a is connected to the first datum surface 311 via the first thermal interface material 510.

In this way, the first thermal interface material 510 fills the gap between the first heater 120a and the first datum surface 311, so that a heat exchange efficiency between the first heater 120a and the liquid cooling board 300 is high, and the liquid cooling board 300 implements an improved heat dissipation effect for the first heater 120a.

For example, the first heater 120a may be a first inductor.

For example, the power factor correction circuit includes a power factor correction inductor, and the charge-discharge circuit includes a charge-discharge inductor. Both the power factor correction inductor and the charge-discharge inductor may be the first inductor.

In examples where the first power conversion board 100 includes a plurality of first power board heaters 120 and the first power board heaters 120 are connected to the first surface structure 310, the plurality of first power board heaters 120 further include a second heater 120b. A size of the first heater 120a in the thickness direction of the liquid cooling board 300 is greater than a size of the second heater 120b in the thickness direction of the liquid cooling board 300. A first thermal conductive pad 410 is disposed between the second heater 120b and the first datum surface 311, and the second heater 120b is connected to the first datum surface 311 via the first thermal conductive pad 410.

In this way, as the first heater 120a is connected to the first datum surface 311, the first thermal conductive pad 410 can fill the gap between the second heater 120b and the first datum surface 311. Hence, the first heater 120a and the second heater 120b, which have a small difference in size in the thickness direction of the liquid cooling board 300, can both realize heat dissipation through the liquid cooling board 300.

For example, the first thermal conductive pad 410 is elastic, that is, the first thermal conductive pad 410 is an elastic pad. Hence, both sides of the first thermal conductive pad 410 are closely attached to the first datum surface 311 and the second heater 120b, realizing a high efficiency of heat exchange between the second heater 120b and the liquid cooling board 300 through the first thermal conductive pad 410, and thereby the liquid cooling board 300 implements an improved heat dissipation effect for the second heater 120b.

For example, the second heater 120b may be a first capacitor.

For example, the power factor correction circuit includes a power factor correction A-phase capacitor, a power factor correction B-phase capacitor, and a power factor correction C-phase capacitor. The power factor correction A-phase capacitor, the power factor correction B-phase capacitor, and the power factor correction C-phase capacitor may be all first capacitors.

In examples where the first power conversion board 100 includes a plurality of first power board heaters 120 and the plurality of first power board heaters 120 are connected to the first surface structure 310, the first surface structure 310 further includes a first boss structure 312 protruding from the first datum surface 311 toward the first substrate 110, and the plurality of first power board heaters 120 further include a third heater 120c. A size of the first heater 120a in the thickness direction of the liquid cooling board 300 is greater than a size of the third heater 120c in the thickness direction of the liquid cooling board 300. An orthographic projection of the first heater 120a on a reference plane is located within an orthographic projection of the first datum surface 311 on the reference plane, and the first heater 120a is connected to the first datum surface 311. At least part of an orthographic projection of the third heater 120c on the reference plane is located within an orthographic projection of an end surface of the first boss structure 312 away from the first datum surface 311 on the reference plane, and the third heater 120c is connected to the end surface of the first boss structure 312 away from the first datum surface 311.

In this way, as the first heater 120a is connected to the first datum surface 311, the first boss structure 312 can fill the gap between the third heater 120c and the first datum surface 311. Hence, the first heater 120a and the third heater 120c, which have a large difference in size in the thickness direction of the liquid cooling board 300, can both realize heat dissipation through the liquid cooling board 300.

For example, the end surface of the first boss structure 312 away from the first datum surface 311 is perpendicular to the thickness direction of the liquid cooling board 300.

For example, a second thermal interface material 520 is provided between the third heater 120c and the end surface of the first boss structure 312 away from the first datum surface 311. The third heater 120c is connected to the end surface of the first boss structure 312 away from the first datum surface 311 via the second thermal interface material 520.

In this way, the second thermal interface material 520 fills the gap between the third heater 120c and the end surface of the first boss structure 312 away from the first datum surface 311, so that a heat exchange efficiency between the third heater 120c and the liquid cooling board 300 is high, and the liquid cooling board 300 implements an improved heat dissipation effect for the third heater 120c.

In some examples, the size of the second heater 120b in the thickness direction of the liquid cooling board 300 is greater than the size of the third heater 120c in the thickness direction of the liquid cooling board 300.

For example, the third heater 120c may be a first power tube component.

For example, the power factor correction circuit includes a power factor correction A-phase power tube component, a power factor correction B-phase power tube component, and a power factor correction C-phase power tube component. The charge-discharge circuit includes a charge-discharge power tube component. The power factor correction A-phase power tube component, the power factor correction B-phase power tube component, the power factor correction C-phase power tube component, and the charge-discharge power tube component may be all the first power tube components.

Figure 5 is an exploded view of a first power conversion board of a power conversion module according to an embodiment of the present disclosure.

As shown in Figure 5 and with reference to Figure 4, in some possible embodiments, the third heater 120c includes a first heating element 121c and a first heat dissipation board 122c. The first heating element 121c is disposed on the first substrate 110, the first heat dissipation board 122c is disposed between the first heating element 121c and the first boss structure 312, a side of the first heat dissipation board 122c is connected to the first heating element 121c, and another side of the first heat dissipation board 122c is connected to the end surface of the first boss structure 312 away from the first datum surface 311.

In this way, a heat exchange area between the first heat dissipation board 122c and the liquid cooling board 300 is large, which contributes to improve the heat dissipation effect of the liquid cooling board 300 on the first heating element 121c.

For example, a third thermal interface material 530 is provided between the first heating element 121c and the first heat dissipation board 122c, and the first heating element 121c is connected to the first heat dissipation board 122c via the third thermal interface material 530.

For example, the first heat dissipation board 122c may include, but is not limited to, a metal heat dissipation board or a ceramic heat dissipation board etc..

For example, the first heat dissipation board 122c is perpendicular to the thickness direction of the liquid cooling board 300.

In examples where the third heater 120c is the first power tube component, the first heating element 121c may be a first power tube.

In possible embodiments, the third heater 120c comprises a plurality of first heating elements 121c, and a side of the first heat dissipation board 122c is connected to the plurality of first heating elements 121c.

In this way, the plurality of first heating elements 121c exchange heat with the liquid cooling board 300 through the first heat dissipation board 122c, realizing a compact structure, and thereby the first heat dissipation board 122c can be arranged easily. In addition, a difficulty of disposing the first boss structure 312 connected to the first heat dissipation board 122c can be reduced.

In possible embodiments, the first heating element 121c includes a first element body 1211c and a first pin 1212c. The first element body 1211c is disposed on the first substrate 100 via the first pin 1212c. A plane where a length direction of the first element body 1211c and a width direction of the first element body 1211c are located is parallel to the first heat dissipation board 122c. A side of the first element body 1211c away from the first substrate 110 is connected to the first heat dissipation board 122c. A length of the first element body 1211c and a width of the first element body 1211c are both greater than a thickness of the first element body 1211c.

In this way, a heat exchange area between the first element body 1211c and the first heat dissipation board 122c is large and the heat exchange efficiency is high, which contributes to improve the heat dissipation efficiency of the liquid cooling board 300 on the first heating element 121c.

For example, the third thermal interface material 530 is provided between the first element body 1211c and the first heat dissipation board 122c, and the first element body 1211c is connected to the first heat dissipation board 122c via the third thermal interface material 530.

As shown in Figure 4, the second surface structure 320 includes a second datum surface 321.

For example, the second datum surface 321 is perpendicular to the thickness direction of the liquid cooling board 300.

In examples where the second power conversion board 200 includes a plurality of second power board heaters 220 and the plurality of second power board heaters 220 are connected to the second surface structure 320, the plurality of second power board heaters 220 include a fourth heater 220a which is connected to the second datum surface 321.

In this way, a heat conduction path between the fourth heater 220a and the liquid cooling board 300 is short, and the liquid cooling board 300 implements an improved heat dissipation effect for the fourth heater 220a.

For example, a fourth thermal interface material 540 is provided between the fourth heater 220a and the second datum surface 321, and the fourth heater 220a is connected to the second datum surface 321 via the fourth thermal interface material 540.

In this way, the fourth thermal interface material 540 fills the gap between the fourth heater 220a and the second datum surface 321, so that a heat exchange efficiency between the fourth heater 220a and the liquid cooling board 300 is high, and the liquid cooling board 300 implements an improved heat dissipation effect for the fourth heater 220a.

For example, the fourth heater 220a may be a second inductor.

For example, the inverter circuit includes an inverter inductor, and the inverter inductor may be a second inductor.

In examples where the second power conversion board 200 includes a plurality of second power board heaters 220 and the plurality of second power board heaters 220 are connected to the second surface structure 320, the plurality of second power board heaters 220 further include a fifth heater 220b. A size of the fourth heater 220a in the thickness direction of the liquid cooling board 300 is greater than a size of the fifth heater 220b in the thickness direction of the liquid cooling board 300. A second thermal conductive pad 420 is disposed between the fifth heater 220b and the second datum surface 321, and the fifth heater 220b is connected to the second datum surface 321 via the second thermal conductive pad 420.

In this way, as the fourth heater 220a is connected to the second datum surface 321, the second thermal conductive pad 420 can fill the gap between the fifth heater 220b and the second datum surface 321. Hence, the fourth heater 220a and the fifth heater 220b, which have a small difference in size in the thickness direction of the liquid cooling board 300, can both realize heat dissipation through the liquid cooling board 300.

For example, the second thermal conductive pad 420 is elastic, that is, the second thermal conductive pad 420 is an elastic pad. Hence, both sides of the second thermal conductive pad 420 are closely attached to the second datum surface 321 and the fifth heater 220b, realizing a high efficiency of heat exchange between the fifth heater 220b and the liquid cooling board 300 through the second thermal conductive pad 420, and thereby the liquid cooling board 300 implements an improved heat dissipation effect for the fifth heater 220b.

For example, the fifth heater 220b may be a second capacitor.

For example, the inverter circuit includes an inverter A-phase capacitor, an inverter B-phase capacitor, and an inverter C-phase capacitor. The inverter A-phase capacitor, the inverter B-phase capacitor, and the inverter C-phase capacitor may be all second capacitors.

In examples where the second power conversion board 200 includes a plurality of second power board heaters 220 and the plurality of second power board heaters 220 are connected to the second surface structure 320, the second surface structure 320 further includes a second boss structure 322 protruding from the second datum surface 321 toward the second substrate 210. The plurality of second power board heaters 220 further include a sixth heater 220c. A size of the fourth heater 220a in the thickness direction of the liquid cooling board 300 is greater than a size of the sixth heater 220c in the thickness direction of the liquid cooling board 300. An orthographic projection of the fourth heater 220a on a reference plane is located within an orthographic projection of the second datum surface 321 on the reference plane, and the fourth heater 220a is connected to the second datum surface 321. At least part of an orthographic projection of the sixth heater 220c on the reference plane is located within an orthographic projection of an end surface of the second boss structure 322 away from the second datum surface 321 on the reference plane, and the sixth heater 220c is connected to the end surface of the second boss structure 322 away from the second datum surface 321.

In this way, as the fourth heater 220a is connected to the second datum surface 321, the second boss structure 322 can fill the gap between the sixth heater 220c and the second datum surface 321. Hence, the fourth heater 220a and the sixth heater 220c, which have a large difference in size in the thickness direction of the liquid cooling board 300, can both realize heat dissipation through the liquid cooling board 300.

For example, the end surface of the second boss structure 322 away from the second datum surface 321 is perpendicular to the thickness direction of the liquid cooling board 300.

For example, a fifth thermal interface material 550 is provided between the sixth heater 220c and the end surface of the second boss structure 322 away from the second datum surface 321. The sixth heater 220c is connected to the end surface of the second boss structure 322 away from the second datum surface 321 via the fifth thermal interface material 550.

In this way, the fifth thermal interface material 550 fills the gap between the sixth heater 220c and the end surface of the second boss structure 322 away from the second datum surface 321, so that a heat exchange efficiency between the sixth heater 220c and the liquid cooling board 300 is high, and the liquid cooling board 300 implements an improved heat dissipation effect for the sixth heater 220c.

In some examples, the size of the fifth heater 220b in the thickness direction of the liquid cooling board 300 is greater than the size of the sixth heater 220c in the thickness direction of the liquid cooling board 300.

For example, the sixth heater 220c may be a second power tube component.

For example, the inverter circuit includes an inverter A-phase power tube component, an inverter B-phase power tube component, and an inverter C-phase power tube component. The inverter A-phase power tube component, the inverter B-phase power tube component, and the inverter C-phase power tube component may be the second power tube components.

In some possible embodiments, the sixth heater 220c includes a second heating element 221c and a second heat dissipation board 222c. The second heating element 221c is disposed on the second substrate 210, the second heat dissipation board 222c is disposed between the second heating element 221c and the second boss structure 322, a side of the second heat dissipation board 222c is connected to the second heating element 221c, and another side of the second heat dissipation board 222c is connected to the end surface of the second boss structure 322 away from the second datum surface 321.

In this way, a heat exchange area between the second heat dissipation board 222c and the liquid cooling board 300 is large, which contributes to improve the heat dissipation effect of the liquid cooling board 300 on the second heating element 221c.

For example, a sixth thermal interface material 560 is provided between the second heating element 221c and the second heat dissipation board 222c, and the second heating element 221c is connected to the second heat dissipation board 222c via the sixth thermal interface material 560.

For example, the second heat dissipation board 222c may include, but is not limited to, a metal heat dissipation board or a ceramic heat dissipation board.

For example, the second heat dissipation board 222c is perpendicular to the thickness direction of the liquid cooling board 300.

In examples where the sixth heater 220c is the second power tube component, the second heating element 221c may be a second power tube.

In possible embodiments, the sixth heater 220c comprises a plurality of second heating elements 221c, and a side of the second heat dissipation board 222c is connected to the plurality of second heating elements 221c.

In this way, the plurality of second heating elements 221c exchange heat with the liquid cooling board 300 through the second heat dissipation board 222c, realizing a compact structure, and thereby the second heat dissipation board 222c can be arranged easily. In addition, a difficulty of disposing the second boss structure 322 connected to the second heat dissipation board 222c can be reduced.

In possible embodiments, the second heating element 221c includes a second element body 2211c and a second pin. The second element body 2211c is disposed on the second substrate 210 via the second pin. A plane where a length direction of the second element body 2211c and a width direction of the second element body 2211c are located is parallel to the second heat dissipation board 222c. A side of the second element body 2211c away from the second substrate 210 is connected to the second heat dissipation board 222c. A length of the second element body 2211c and a width of the second element body 2211c are both greater than a thickness of the second element body 2211c.

In this way, a heat exchange area between the second element body 2211c and the second heat dissipation board 222c is large and the heat exchange efficiency is high, which contributes to improve the heat dissipation efficiency of the liquid cooling board 300 on the second heating element 221c.

For example, the sixth thermal interface material 560 is provided between the second element body 2211c and the second heat dissipation board 222c, and the second element body 2211c is connected to the second heat dissipation board 222c via the sixth thermal interface material 560.

In some possible implementations, the casing includes a first cover shell and a second cover shell. The first cover shell and the second cover shell are arranged oppositely along the thickness direction of the liquid cooling board 300, and the first power conversion board 100, the liquid cooling board 300 and the second power conversion board 200 are located between the first cover shell and the second cover shell. The first power conversion board 100 is located between the second power conversion board 200 and the first cover shell, the first power conversion board 100 is fixedly connected to the first cover shell, the first cover shell is fixedly connected to the liquid cooling board 300, and the first power conversion board 100 is pressed onto the liquid cooling board 300 by the first cover shell. The second power conversion board 200 is located between the first power conversion board 100 and the second cover shell, the second power conversion board 200 is fixedly connected to the second cover shell, the second cover shell is fixedly connected to the liquid cooling board 300, and the second power conversion board 200 is pressed onto the liquid cooling board 300 by the second cover shell.

In this way, the liquid cooling board 300 can be closely attached to the first power conversion board 100 and the second power conversion board 200, so that the liquid cooling board 300 implements an improved heat dissipation effect for both the first power conversion board 100 and the second power conversion board 200.

For example, the first cover shell and the second cover shell jointly enclose and form an inner cavity of the casing.

It should be finally noted that the above embodiments are only for illustrating the technical solutions of the present disclosure, rather than to limit the present disclosure. Although the present disclosure is described in detail with reference to the foregoing embodiments, those skilled in the art should understand that modifications can be made on the technical solutions recorded in the foregoing embodiments, or equivalent substitutions can be made on some or all of the technical features. Such modifications or substitutions do not deviate the essence of the corresponding technical solutions from the scope of the technical solutions in the embodiments of the present disclosure.

## Claims

1. A power conversion module, comprising a first power conversion board, a second power conversion board and a liquid cooling board,
wherein the first power conversion board, the liquid cooling board and the second power conversion board are stacked along a thickness direction of the liquid cooling board, the liquid cooling board is located between the first power conversion board and the second power conversion board, and two side surfaces of the liquid cooling board in the thickness direction are respectively connected to the first power conversion board and the second power conversion board.

2. The power conversion module according to claim 1, wherein
the first power conversion board comprises a first substrate and a first power board heater disposed on the first substrate, the liquid cooling board is located on a side of the first power board heater away from the first substrate, and the first power board heater is connected to one side surface of the liquid cooling board in the thickness direction; and/or
the second power conversion board comprises a second substrate and a second power board heater disposed on the second substrate, the liquid cooling board is located on a side of the second power board heater away from the second substrate, and the second power board heater is connected to another side surface of the liquid cooling board in the thickness direction.

3. The power conversion module according to claim 2, wherein
the first substrate comprises a first region and a second region, and the first power board heater is disposed in the first region;
the second substrate comprises a third region and a fourth region, and the second power board heater is disposed in the third region;
an orthographic projection of the first region on a reference plane at least partially overlaps an orthographic projection of the third region on the reference plane;
the orthographic projection of the first region on the reference plane and the orthographic projection of the third region on the reference plane are both located within an orthographic projection of the liquid cooling board on the reference plane; and
an orthographic projection of the second region on the reference plane and an orthographic projection of the fourth region on the reference plane are both located outside the orthographic projection of the liquid cooling board on the reference plane; and
wherein the reference plane is perpendicular to the thickness direction of the liquid cooling board.

4. The power conversion module according to claim 2, wherein
the liquid cooling board comprises a first surface structure, and the first surface structure is located on a side of the liquid cooling board in the thickness direction; and
the first surface structure comprises a first datum surface, the first power conversion board comprises a plurality of first power board heaters, the plurality of first power board heaters comprise a first heater and a second heater, a size of the first heater in the thickness direction of the liquid cooling board is greater than a size of the second heater in the thickness direction of the liquid cooling board, the first heater is connected to the first datum surface, a first thermal conductive pad is disposed between the second heater and the first datum surface, and the second heater is connected to the first datum surface via the first thermal conductive pad.

5. The power conversion module according to claim 2, wherein
the liquid cooling board comprises a first surface structure, and the first surface structure is located on a side of the liquid cooling board in the thickness direction;
the first surface structure comprises a first datum surface and a first boss structure protruding from the first datum surface toward the first substrate, the first power conversion board comprises a plurality of first power board heaters, the plurality of first power board heaters comprise a first heater and a third heater, a size of the first heater in the thickness direction of the liquid cooling board is greater than a size of the third heater in the thickness direction of the liquid cooling board;
an orthographic projection of the first heater on a reference plane is located within an orthographic projection of the first datum surface on the reference plane, and the first heater is connected to the first datum surface; and
at least part of an orthographic projection of the third heater on the reference plane is located within an orthographic projection of an end surface of the first boss structure away from the first datum surface on the reference plane, and the third heater is connected to the end surface of the first boss structure away from the first datum surface; and
wherein the reference plane is perpendicular to the thickness direction of the liquid cooling board.

6. The power conversion module according to claim 5, wherein the third heater comprises a first heating element and a first heat dissipation board;
the first heating element is disposed on the first substrate, the first heat dissipation board is disposed between the first heating element and the first boss structure, a side of the first heat dissipation board is connected to the first heating element, and another side of the first heat dissipation board is connected to the end surface of the first boss structure away from the first datum surface.

7. The power conversion module according to claim 6, wherein the third heater comprises a plurality of first heating elements, and a side of the first heat dissipation board is connected to the plurality of first heating elements.

8. The power conversion module according to claim 6, wherein the first heating element comprises a first element body and a first pin, the first element body is disposed on the first substrate via the first pin, a plane where a length direction of the first element body and a width direction of the first element body are located is parallel to the first heat dissipation board, and a side of the first element body away from the first substrate is connected to the first heat dissipation board; and
wherein a length of the first element body and a width of the first element body are both greater than a thickness of the first element body.

9. The power conversion module according to any one of claims 1 to 8, further comprising a first cover shell and a second cover shell, wherein
the first cover shell and the second cover shell are arranged oppositely along the thickness direction of the liquid cooling board, and the first power conversion board, the liquid cooling board and the second power conversion board are located between the first cover shell and the second cover shell;
the first power conversion board is located between the second power conversion board and the first cover shell, the first power conversion board is fixedly connected to the first cover shell, the first cover shell is fixedly connected to the liquid cooling board, and the first power conversion board is pressed onto the liquid cooling board by the first cover shell; and
the second power conversion board is located between the first power conversion board and the second cover shell, the second power conversion board is fixedly connected to the second cover shell, the second cover shell is fixedly connected to the liquid cooling board, and the second power conversion board is pressed onto the liquid cooling board by the second cover shell.

10. An uninterruptible power supply, comprising a cabinet and the power conversion module according to any one of claims 1 to 9, wherein the power conversion module is disposed in the cabinet.
